Europäisches Patentamt

European Patent Office

Office européen des brevets

(11) Publication number : **0 616 049 A2**

(12) # EUROPEAN PATENT APPLICATION

(21) Application number : **94301942.2**

(22) Date of filing : **18.03.94**

(51) Int. Cl.⁵ : **C23C 18/20, C08J 7/14**

(30) Priority : **18.03.93 US 33207**

(43) Date of publication of application :
**21.09.94 Bulletin 94/38**

(84) Designated Contracting States :
**DE ES FR GB IT NL**

(71) Applicant : **GENERAL ELECTRIC COMPANY**
**1 River Road**
**Schenectady, NY 12345 (US)**

(72) Inventor : **Chao, Herbert Shin-I**
**29 Hampshire Way**
**Schenectady, New York 12309 (US)**

(74) Representative : **Pratt, Richard Wilson et al**
**London Patent Operation**
**G.E. Technical Services Co. Inc.**
**Essex House**
**12/13 Essex Street**
**London WC2R 3AA (GB)**

(54) **Improving adhesion of metal coatings to tetracarboxybiphenyl polyimides.**

(57)    Adherent metal coatings are provided on articles comprising a polyimide of 3,3',4,4'-tetracarboxybiphenyl and 4-aminoethyl ether by non-electrolytic metal deposition (e.g., physical vapor deposition or electroless deposition) following a treatment method comprising steps of contact with strong nitric acid, with strong sulfuric acid and with an aqueous alkaline permanganate solution, the first two steps being followed by a water rinse. The metallized article is then heat-treated for at least about 30 minutes at a temperature in the range of about 60-100°C. Optional steps are treatment with an alkaline solution after sulfuric acid treatment and deposition of a further metal coating such as an electrolytic coating ; said further metal deposition is also followed by a heat treatment step.

EP 0 616 049 A2

This invention relates to the improvement of adhesion of metal coatings to polyimide surfaces, and more particularly their adhesion to surfaces of polyimides of tetracarboxybiphenyls.

Polyimides of the type prepared by the reaction of 3,3',4,4'-tetracarboxybiphenyl or its functional derivatives with various aromatic diamines, especially 4-aminophenyl ether, are noted for their solvent resistance, thermal stability, good mechanical properties and low dielectric constant. They are in wide use for various purposes, including as substrates for metallization. Metallized 3,3',4,4'-tetracarboxybiphenyl polyimides are useful in printed circuit boards, both rigid and flexible. For that purpose, the metal layer is patterned by additive, semi-additive or subtractive methods known in the art.

For the most part, such polyimides have been metallized by methods involving the use of copper foil. Typical methods of this type are disclosed in European patent applications 431,636 and 459,452, German Offenlegungsschrift 3,215,944 and Japanese Kokai 56/118,204, 58/190,091 and 58/190,093. Another method, disclosed in Japanese Kokai 03/274,261, involved vacuum sputtering of a titanium layer on plasma-treated polyimide, followed by vacuum deposition of a titanium and then a copper layer. Adhesion of such metal layers is generally measured as "peel strength", which is the force required to peel an adherent metal layer from a substrate under controlled conditions.

The adhesion of 3,3',4,4'-tetracarboxybiphenyl polyimides to metal layers deposited thereon by electroless deposition is generally poor. Therefore, electroless methods have not been commercially employed in connection with the use of such polyimides.

The present invention provides a method for treatment of surfaces of certain 3,3',4,4'-tetracarboxybiphenyl polyimides to improve adhesion of metal layers, especially those deposited by electroless deposition. Said method requires only readily available chemicals and relatively short treatment times, and thus may be practiced quite inexpensively and simply.

In one of its aspects, therefore, the invention is a method for depositing an adherent metal layer on the surface of a resinous substrate comprising a polyimide of 3,3',4,4'-tetracarboxybiphenyl and 4-aminophenyl ether, said method comprising the steps of:

contacting at least a portion of said surface with nitric acid, of at least about 60% concentration by weight,

contacting said surface with sulfuric acid of at least about 90% concentration by weight,

each of said contact steps being followed by a water rinse;

contacting said surface with an aqueous alkaline solution of a water-soluble permanganate;

non-electrolytically depositing a metal layer on said surface; and

heat treating the metal-coated surface at a temperature in the range of about 60-100°C for at least about 30 minutes.

The polyimides to which the present invention applies are typically prepared by the reaction of 3,3',4,4'-tetracarboxybiphenyl or a functional derivative thereof, typically the dianhydride, with 4-aminophenyl ether, optionally in admixture with minor proportions of other dianhydrides and/or diamines. When used hereinafter, the word "biphenyl polyimides" will generally mean those prepared from said compounds. Such polyimides are commercially available from Ube Industries under the trade name "Upilex", with "Upilex-R" being an example.

Prior to the method of this invention, it is frequently preferred to clean the surface of the substrate with a degreasing agent, typically a halohydrocarbon such as 1,1,2-trichlorotrifluoroethane, or with a conventional detergent.

In the first step of the method of the invention, the biphenyl polyimide surface is contacted with nitric acid having a concentration of at least about 60% and preferably about 70-71% by weight. The time of contact of the substrate with the nitric acid is typically from about 30 seconds to about 10 minutes, preferably about 1-5 minutes. The contact temperature is ordinarily in the range of about 10-50°C. A water rinse is employed following the nitric acid treatment, and the substrate is then preferably dried, for example by air drying, to avoid dilution of the sulfuric acid employed in the next step.

In said step, the biphenyl polyimide surface is contacted with sulfuric acid of at least about 90% concentration by weight. Commercial concentrated sulfuric acid, having a concentration of at least about 95%, is generally preferred for reasons of convenience and particular suitability. The treatment temperature is not critical but is most often in the range of about 10-50°C. Treatment time should be at least about 10 seconds and preferably about 20-60 seconds. A second water rinse follows the sulfuric acid treatment step.

It is within the scope of the invention to include contact of the substrate with an aqueous alkali metal hydroxide solution after the sulfuric acid treatment. Sodium hydroxide and potassium hydroxide are preferred by reason of their availability and particular suitability. Said solution typically has a concentration in the range of about 4-8 $\underline{N}$, preferably about 4-6 $\underline{N}$.

While the alkali metal hydroxide treatment step is not detrimental, it is not necessary and therefore gen-

2

erally not preferred.

The substrate is then contacted with an aqueous alkaline solution of a water-soluble permanganate, usually sodium or potassium permanganate. The concentration of permanganate therein is usually about 0.05-0.15 $\underline{N}$, and the alkali concentration about 1.0-1.5 $\underline{N}$. Typical contact temperatures and times are in the range of about 50-100° C and about 3-10 minutes.

Following the permanganate treatment step, it is highly preferred to contact the substrate with a reducing agent to remove any manganese residue. The reducing agent is preferably in the form of an aqueous solution. Solutions of hydroxylamine salts are particularly useful for this purpose; they are commercially available under such tradenames as "Shipley Circuposit® MLB 216".

After the above-described treatment steps have been performed, a metal layer is deposited non-electrolytically on the surface of the substrate. Such deposition may be by conventional methods such as physical vapor and electroless deposition.

The invention is particularly advantageous with electroless metal deposition. Such deposition may be by conventional methods involving art-recognized, commercially available reagents. Methods of this type generally begin with a pretreatment to aid in the absorption of the electroless deposition catalyst, typically with a reagent such as Shipley Cleaner-Conditioner 1175A which is an alkaline solution containing organic compounds. This may be followed by surface activation employing, for example, Shipley Cataprep® 404 containing sodium bisulfate and various surfactants; and then by treatment with an acidic palladium-containing solution as catalyst, illustrated by Shipley Cataposit® 44 which comprises tin and palladium compounds, the palladium being the principal catalytic species.

After a water rinse, the substrate may be immersed in a solution of Shipley Cuposit® Accelerator 19, a fluoboric acid-containing formulation used to remove tin, or an equivalent thereof. It may then be further rinsed with water and treated with one or more electroless plating solutions.

Electroless plating baths are well known in the art and are generally described, for example, in Kirk-Othmer, *Encyclopedia of Chemical Technology,* Third Edition, Volume 8, the contents of which are incorporated herein by reference. The selection of a particular electroless plating bath or process is not critical to the invention. The contents of the bath and the plating parameters such as temperature, pH and immersion time will of course depend on the metal to be deposited. Suitable plating baths include Shipley Cuposit® 250 and 251 and Enthone Enplate® NI-426. The former two are electroless copper solutions and the latter an electroless nickel solution.

Following metallization by electroless deposition, the metal layer is heat-treated at a temperature in the range of about 60-100°C for a period of time sufficient to stabilize adhesion properties. Said time period is at least 30 minutes, most often about 1-4 hours and preferably about 2-3 hours.

A further metal coating, preferably of copper, may be deposited on the substrate after the initial non-electrolytic metal deposition. Deposition of said further coating may be by conventional methods including electroless and electrolytic deposition, the details of which are likewise known to those skilled in the art. Following deposition of the further metal coating, the article should again be heat-treated, in this instance for a period from about 30 minutes to about 5 hours and at a temperature in the range of about 100-150°C, preferably about 100-125°C.

Metallized articles comprising biphenyl polyimide substrates subjected to treatment by the above-described method are another aspect of the invention. They have substantially improved adhesion of the metal to the resin surface, in comparison with untreated substrates. This is shown by the results of a peel test (IPC method 2.4.8) in which strips of tape, 3.2 mm. wide, are used to mask portions of the metallized surface after deposition of electrolytic copper and the exposed copper is etched away with concentrated nitric acid. The substrate is rinsed thoroughly in water, after which the tape is removed and the remaining copper strips subjected to a 90° peel test.

The invention is illustrated by the following examples.

## Examples 1-2

Samples of 127-micron films of "Upilex-R" polyimide were mounted on a solid support so that one surface was exposed, and the surface was cleaned with a commercially available detergent. One sample was treated with concentrated nitric acid for 2 minutes at room temperature; concentrated sulfuric acid for 30 seconds at room temperature; and "Shipley Circuposit® MLB 213", an aqueous solution which, as employed herein, was 1.2 $\underline{N}$ in sodium hydroxide and 0.1 $\underline{N}$ in sodium permanganate, for 5 minutes at 75°C. Each of the first two steps was followed by an aerated water rinse and the first step also by air drying. Another sample was treated with 5 $\underline{N}$ aqueous potassium hydroxide solution following the sulfuric acid treatment. Following the permanganate treatment, the substrates were dipped in "Shipley Circuposit MLB 216" hydroxylamine solution at 55°C.

The polyimide films were then coated with electroless copper layers by the following scheme of operations:

Water rinse-2 minutes;
Shipley Cleaner-Conditioner 1175A-5 minutes, 2.5% by volume, 75°C;
Water rinse-2 minutes;
Shipley Cataprep 404-1 minute, 270 g/l;
Shipley Cataposit 44-3 minutes, 1.5% by volume, with Cataprep 404 at 270 g/l, 44°C;
Water rinse-2 minutes;
Shipley Accelerator 19-3 minutes, 16% by volume;
Water rinse-2 minutes;
Shipley Cuposit 251 electroless copper plating solution-2 minutes, 48°C.

The metallized films were heat-treated for 2 hours at 75°C. Finally, electrolytic copper coatings were deposited by treatment in an acid copper bath for 60 minutes at a current density of 0.032 A/cm.$^2$.

Peel test strips were created in the electroplated films and the films were heat-treated for the times listed in Table I and subjected to the above-described peel strength test in comparison with various controls. The results are given in the following table, with the controls designated "C".

| Example | HNO$_3$ | H$_2$SO$_4$ | KOH | NaMnO$_4$ | Peel strength, g/mm @ heat treatment time, hrs. | | | |
|---------|------|--------|-----|---------|-----|-----|-----|-----|
| | | | | | 1 | 2 | 3 | 4 |
| 1 | Yes | Yes | No | Yes | 188 | 197 | 226 | - - - |
| 2 | Yes | Yes | Yes | Yes | 127 | 192 | 209 | 220 |
| C1 | No | Yes | Yes | Yes | 127 | 138 | 159 | - - - |
| C2 | Yes | No | Yes | Yes | 81 | 129 | 145 | - - - |
| C3 | Yes | Yes | No | No | * | | | |
| C4 | Yes | Yes | Yes | No | * | | | |
| C5 | Yes | No | No | Yes | 82 | 138 | 152 | - - - |
| C6 | Yes | No | Yes | No | 57 | 77 | 72 | - - - |
| C7 | No | Yes | No | Yes | 104 | 84 | 95 | - - - |
| C8 | No | Yes | Yes | No | * | | | |
| C9 | No | No | No | Yes | 118 | 88 | 68 | - - - |
| C10 | No | No | Yes | Yes | 145 | 154 | 175 | - - - |
| C11 | Yes | No | No | No | * | | | |
| C12 | No | Yes | No | No | * | | | |
| C13 | No | No | No | No | * | | | |

*Did not adhere.

The results in the table show that with heat treatment periods of 2-4 hours, there is little change in results whether or not a potassium hydroxide treatment step is employed. When the nitric acid step is omitted (control 1), adhesion is uniformly worse than under the conditions of the invention at heat treatment times of 2 hours or greater. Under most of the other conditions represented by the controls, adhesion is substantially inferior or non-existent.

## Example 3

The procedure of Example 2 was repeated, except that the electroless copper bath was replaced by Enthone Enplate NI-426 electroless nickel bath which was employed for 2 minutes at 53°C and a pH of 6.2. The peel strengths after 1, 2, 3 and 5 hours were 59, 75, 77 and 82 g/mm, respectively.

## Example 4

A film of "Upilex-R" was treated in accordance with Example 1 and blown dry with filtered nitrogen. It was then placed in a vacuum chamber and about 1500 Ångstroms of copper was deposited by physical vapor deposition. The metallized film was attached to a backing plate and electrolytic copper was deposited thereon to a total copper thickness of 42.5 microns. Peel test strips were created and heat-treated and peel strength measurements were taken as in Example 1. The peel strength was 161 g/mm, as compared to no adhesion for a control not treated in accordance with the invention.

## Claims

1. A method for depositing an adherent metal layer on the surface of a resinous substrate comprising a polyimide of 3,3',4,4'-tetracarboxybiphenyl and 4-aminophenyl ether, said method comprising the steps of:
   contacting at least a portion of said surface with nitric acid, of at least about 60% concentration by weight,
   contacting said surface with sulfuric acid of at least about 90% concentration by weight,
   each of said contact steps being followed by a water rinse;
   contacting said surface with an aqueous alkaline solution of a water-soluble permanganate;
   non-electrolytically depositing a metal layer on said surface; and
   heat treating the metal-coated surface at a temperature in the range of about 60-100°C for at least about 30 minutes.

2. A method according to claim 1 wherein the nitric acid contact step and water rinse are followed by drying of the substrate, and the permanganate contact step is followed by contact with a reducing agent to remove manganese residue.

3. A method according to claim 2 wherein the reducing agent is a hydroxylamine salt solution.

4. A method according to claim 2 wherein the nitric acid concentration is about 70-71% by weight.

5. A method according to claim 4 wherein the nitric acid contact time and temperature are about 1-5 minutes and about 10-50°C, respectively.

6. A method according to claim 2 wherein the sulfuric acid concentration is at least about 95% by weight.

7. A method according to claim 6 wherein the sulfuric acid contact time and temperature are about 20-60 seconds and about 10-50°C, respectively.

8. A method according to claim 2 wherein the aqueous alkaline permanganate solution has a permanganate concentration of about 0.05-0.15 $\underline{N}$ and an alkali concentration of about 1.0-1.5 $\underline{N}$.

9. A method according to claim 8 wherein the aqueous alkaline permanganate solution contact time and temperature are about 3-10 minutes and about 50-100°C, respectively.

10. A method according to claim 2 wherein the surface of the substrate is contacted with an aqueous alkali metal hydroxide solution after contact with the sulfuric acid.

11. A method according to claim 10 wherein the alkali metal hydroxide solution has a concentration in the range of about 4-6 $\underline{N}$.

12. A method according to claim 2 wherein the metal layer is deposited by electroless deposition.

13. A method according to claim 12 wherein the metal is copper or nickel.

14. A method according to claim 12 wherein heat treatment of the metal-coated surface is for a period of about 2-3 hours.

15. A method according to claim 12 wherein a further metal coating is deposited after the non-electrolytic metal layer.

16. A method according to claim 15 wherein said further metal coating is electrolytic copper and its deposition is followed by heat treatment for a period from about 30 minutes to about 5 hours and at a temperature in the range of about 100-150°C.

17. A metallized article comprising a substrate which comprises a polyimide of 3,3',4,4'-tetracarboxybiphenyl and 4-aminophenyl ether, said article being subjected to treatment by the method of claim 1.

18. An article according to claim 17 which has an electroless copper or nickel layer.

19. An article according to claim 18 which has a further metal coating thereon.

20. An article according to claim 19 wherein the further metal coating is electrolytic copper.